# EUROPÄISCHE PATENTSCHRIFT

(11) **EP 0 617 509 B1**
(45) Veröffentlichungstag und Bekanntmachung des Hinweises auf die Patenterteilung: **31.10.2001**
(21) Anmeldenummer: 94104443.0
(22) Anmeldetag: 21.03.1994
(51) Int. Cl.: H03H 7/38, H04L 25/02, H04L 25/08, H02M 3/335, G06F 13/40

(54) **Spannungsversorgung von Wellenleiter-Abschlüssen**
Voltage supply for terminating points of waveguides
Alimentation en tension aux terminaison de guide d'ondes

(30) Priorität: 22.03.1993 DE 4309173
(43) Veröffentlichungstag der Anmeldung: 28.09.1994
(73) Patentinhaber: Fujitsu Siemens Computers GmbH, 81739 München (DE)
(72) Erfinder: Pollmeier, Werner, D-33415 Verl (DE)
(74) Vertreter: Epping, Wilhelm, Dipl.-Ing.

(56) Entgegenhaltungen:
- EP-A- 0 346 572
- WO-A-91/16756
- US-A- 5 081 440

## Beschreibung

### Technisches Gebiet

Die Erfindung betrifft die Versorgung von Abschlußwiderständen mit Vorspannungen in Bus-Systemen mit als Wellenleiter betriebenen Signalleitungen.

### Stand der Technik

Bei elektronischen Geräten, insbesondere bei Datenverarbeitungsanlagen, wird häufig ein Aufbau benutzt, bei dem mehrere Moduln über eine Rückwand verbunden werden. Die Moduln sind steckbar angeordnet. Die Steckkontakte auf der Rückwand werden jeweils miteinander verbunden, so daß parallele Daten-, Adress- und Steuerleitungen gebildet werden. Um Einschwingvorgänge auf diesen Datenleitungen zu vermeiden, werden sie als Wellenleiter betrieben. Dies wird dadurch erreicht, daß sie an beiden Enden mit ihrem Wellenwiderstand abgeschlossen werden.

Um einen Bus mit konkurrierendem Zugriff einzurichten, werden, wie z.B. in der DE OS 1933052 dargestellt, zur Signalisierung elektronische Schalter verwendet, die Wellenleiter an beiden Enden abgeschlossen und die Abschlußwiderstände auf ein vorbestimmtes Potential gegenüber Masse gelegt. Durch Schließen der Schalter wird dann ein Signal erzeugt, das von allen anderen Moduln empfangen wird.

Dazu wird an beide Abschlußwiderstände eine Spannung geführt wie z.B. in US-A-5 081 440 gezeigt. Es hat sich dabei gezeigt, daß für eine ordnungsgemäße Funktion eine sehr stabile und genaue Vorspannung an den Abschlußwiderständen bereitgestellt werden muß, die auch an beiden Abschlußwiderständen bei allen Lastzuständen mit sehr engen Toleranzen gleich sein muß. Wie in dem Ausführungsbeispiel dargestellt, werden Impulsströme von etwa 6A bei Anstiegszeiten von 3ns an den Abschlußwiderständen abgenommen. Eine Pufferung durch Kondensatoren ist, auch aus Platzgründen, nur für etwa 70µs möglich. Um unter allen Betriebsbedingungen einen stabile Versorgungsspannung für die Abschlußwiderstände bereitzustellen, müssten daher unmittelbar an beiden Seiten der Rückwand Stabilisierungsschaltungen oder Schaltnetzteile angeordnet werden. Alternativ könnten auch niederohmige und induktionsarme Leitungen verwendet werden, die beispielsweise mit großem Querschnitt und versilberter Oberfläche ausgeführt sind. Diese Lösungen sind jedoch aufwendig.

Aufgabe der Erfindung ist es, eine stabile und hochgenaue Vorspannung für Abschußwiderstände von einem räumlich entfernten, möglichst für beide Seiten gemeinsamen Netzteil mit geringem Aufwand zu den Abschlußwiderständen zu führen.

### Darstellung der Erfindung

Die Erfindung beruht auf der Beobachtung, daß die Aufgabe durch Weglassen des Siebkondensators im Netzteil gelöst werden kann. Da die überwiegend verwendeten Schaltnetzteile immer zur Siebung eine Drossel verwenden, liegen dann bei der bislang verwendeten Anordung, also bei Verwendung eines Siebkondensators im Netzteil, zwei LC-Glieder in Reihe. Aus den oben genannten Gründen muß eine Regelung der Versorgungsspannung den Sollwert an den Abschlußwiderständen abgreifen. Durch das Weglassen des Siebkondesators und die Einbeziehung der Leitungsinduktivitäten als Teil der Ausgangsdrossel wird damit aus einer Regelstrecke 2.Ordnung eine solche 1.Ordnung, die wesentlich schneller und mit einem Regeler mit hohem Proportionalanteil ausgeregelt werden kann. Die in bekannten Netzteilen übliche Regelung der Ausgangsspannung entfällt oder, sofern vorhanden, wirkt mit geringererm Durchgriff als die Regelung durch die an der Last abgegriffene Spannung.

Insbesondere wird dabei vor und hinter der Siebdrossel im Netzteil bei Belastung der Abschlußwiderstände ein vorübergehender Spannungsanstieg bis zur Begrenzung bei etwa der doppelten Sollspannung auftreten. Durch diesen Effekt kann in der vorgegebenen kurzen Zeit sowohl die benötigte Leistung an den Abschlußwiderständen bereitgestellt als auch die zuvor entnommene Ladung der Pufferkondensatoren ausgeglichen werden.

Ferner ergibt sich, daß unter diesen Bedingungen auch beide Seiten der Rückwand aus demselben Netzteil versorgt werden können. Da die Länge und Ausführung der Zuführungsleitung keinen wesentlichen Einschränkungen unterliegt, können die Zuführungsleitungen gleichlang und als Kabel ausgeführt werden, in dem das Zuführungskabel zu der dem Netzteil näher liegenden Seite länger als notwendig, nämlich gleichlang zu dem auf die andere Seite führenden, gestaltet wird.

### Kurzbeschreibung der Zeichnungen

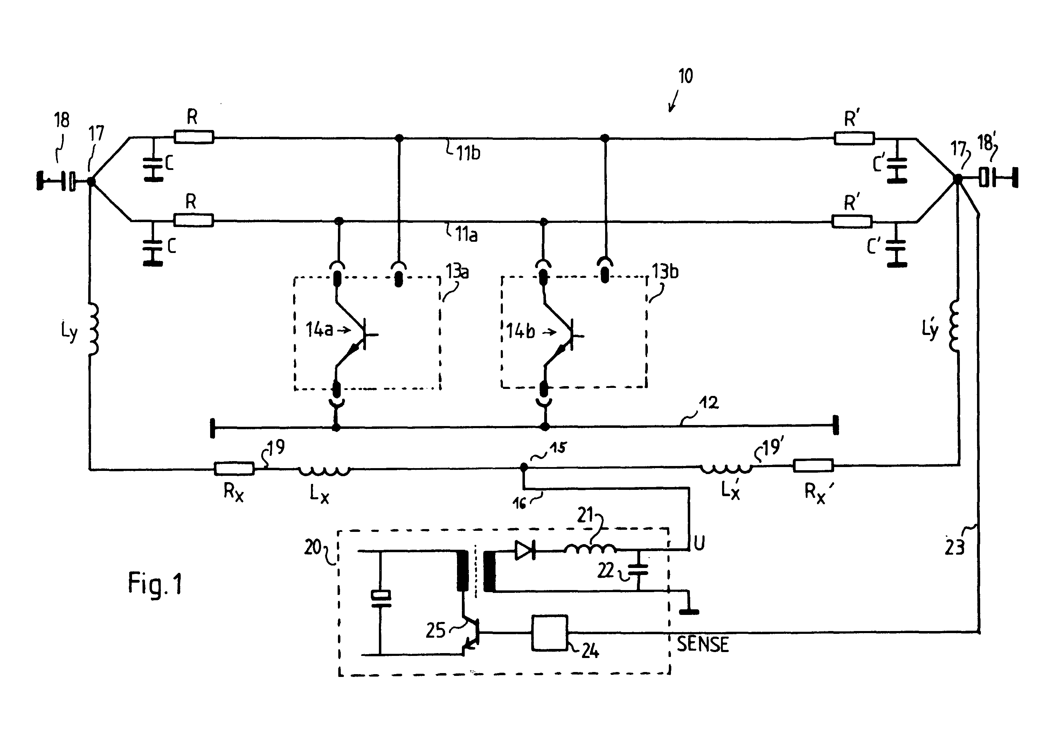

Es zeigt
- Fig. 1: die Versorgung von Abschlußwiderständen mit einer Vorspannung als Prinzipschaltbild.

### Detaillierte Beschreibung der Erfindung

In Fig. 1 ist eine Rückwand 10 mit Moduln 13a und 13b gezeigt. Der Übersichtlichkeit halber sind nur zwei Moduln 13a und 13b und zwei Signalleitungen 11a und 11b sowie die zugehörige Masseleitung 12 dargestellt. Jede der Signalleitungen 11a und 11b hat gegenüber der Masseleitung 12 einen Wellenwiderstand R. Die Abschlußwiderstände R und R' sind einander gleich und haben als Wert eben diesen Wellenwiderstand. Die Signalisierung erfolgt durch elektronische Schalter 14a und 14b in den Moduln 13a und 13b. Die Empfangsschaltungen sind nicht dargestellt. Die den Signalleitungen 11a, 11b fernen Enden der Abschlußwiderstände R und R' sind durch Kondensatoren C, C' wechselstrommäßig an Masse geführt.

Beispielsweise wird ein Bussystem mit 32 Adressleitungen, 64 Signalleitungen und 16 Steuerleitungen verwendet, womit sich insgesamt 112 Leitungen ergeben. Bei einem Abschlußwiderstand von 39 Ohm und einem High-Potential von 2,1V ergibt sich pro Abschlußwiderstand ein Strom von 53mA. Damit ergibt sich auf jeder Seite für die 112 Abschlußwiderstände ein Gesamtstrom von 5,9A. Bei einer Bustaktfrequenz von 50MHz oder höher sind Signalanstiegszeiten von weniger als 3ns gegeben, so daß eine dynamische Last von 2x5,9A bei einer Anstiegszeit von 3ns gegeben ist. Die Versorgungsspannung soll eine Genauigkeit von 5% haben. Für den dynamischen Fehler verbleiben davon 2%, was bei 2,1V Spannung einen maximalen Spannungsabfall von 42mV bedeutet. Bei einer Gesamtkapazität der Stützkondensatoren von 20mF wird dieser Spannungabfall nach 72µs erreicht. Spätestens zu diesem Zeitpunkt wird der Strombedarf durch das Netzteil gedeckt.

In einem Netzteil 20 wird ein Spannung U erzeugt. Das Netzteil 20 enthält eine Siebdrossel 21 am Ausgang, aber keinen Siebkondensator. Der dargestellte Kondensator 22 ist nur ein Schutz- und Entstörkondensator geringer Kapazität. Die Siebdrossel ist gleichfalls geringer als gewöhnlich dimensioniert. Die Spannung wird durch eine Speisung 16 zu einem Einspeisepunkt 15 geführt, von dem aus getrennte, aber gleich ausgeführte Zuleitungen 16 und 16' zu Verteilpunkten 17 und 17' führen. Eine Anordnung des Netzteils 20 etwa in der Mitte der Rückwand 10 ist hierzu nicht notwendig, es wird lediglich sichergestellt, daß die Zuleitungen 16, 16' gleiche Länge und Ausführung haben, also insbesondere gleichen Widerstand und gleiche Induktivität. Ein besonders geringer Leitungswiderstand oder eine besonders geringe Induktivität sind nicht erforderlich. Die zugeleitete Spannung wird an den Verteilpunkten 17 und 17' durch einen Stützkondensator 18, 18' für mittlere Frequenzen gestützt.

Die Spannung wird dann durch kurze, rechts und links gleich gestaltete Vebindungen zu den Abschlußwiderständen R und R' geleitet und dort durch Kondensatoren C und C' hochfrequenzmäßig abgeblockt.

Der Wert der Kondensatoren 18, 18' kann um die Summe der Kapazitäten der Blockkondensatoren C, C' reduziert werden, da diese durch die kurze Verbindung zwischen Siebkondensator 18 und Blockkondensator C,C' zur Siebung beitragen.

Als Kondensatoren C werden induktionsarme Kondensatoren verwendent, insbesondere SMD-Kondensatoren. Damit wird eine induktionsarme Kapazität großen Werts erreicht, die mit einem einzelnen Siebkondensator anstelle des Stützkondensators 22 nicht erreichbar wäre.

Eine Fühlleitung 23 führt von einem Verteilpunkt zu dem Netzteil und dort zu einer Regelungselektronik 24, welche den Schalttransistor 25 beeinflußt. Die Regelungselektronik 24 regelt proportional der Abweichung der rückgeführten Spannung zu einer nicht dargestellten internen Referenzspannung mit hoher Verstärkung und einer Zeitkonstante von z.B. 20µs, die unter der Pufferzeit der Stützkondensatoren liegt. Bei einem Lastwechsel tritt dadurch am Gleichspannungsgenerator und am Ausgang des Netzgerätes ein vorübergehender Spannungsimpuls auf, der funktionsbedingt und beabsichtigt ist.

Wegen der gleichen Gleichstromwiderstände Rx, Rx' der Zuleitungen 19, 19' braucht nur ein Fühleingang SENSE des Netzteils verwendet zu werden. Er braucht nur zu einem der beiden Verteilpunkte, im Beispiel der Fig. 1 ist es 17', geführt zu werden.

Sofern keine geeignete Masseverbindung ohnehin besteht, wird die Rückführung der Vorspannung U auf gleiche Art durchgeführt. Dies ist in Fig. 1 aus Gründen der Übersichtlichkeit nicht dargestellt. Es werden also zwei getrennte, aber gleichartige Masseleitungen von beiden Seiten der Rückwand zu einem gemeinsamen Einspeisepunkt nahe am Netzteil geführt. Der restliche Weg zum Netzteil kann dann durch eine einzige separate Verbindung oder das Chassis geführt werden. Eine Massefühlleitung wird nur an einer Seite, vorzugsweise an derselben wie die Spannungsfühlleitung, angeschlossen.

## Patentansprüche

1. Anordnung zur Spannungsversorgung von Lasten (17) mit hohem Impulsstrombedarf, insbesondere von Wellenleiterabschlüssen, durch ein Netzteil (20) mit den Merkmalen:
- das Netzteil (20) enthält einen Gleichspannungsgenerator, der unmittelbar mit einem ersten Anschluß einer Siebdrossel verbunden ist,
- der zweite Anschluß der Siebdrossel (21) ist mit einem Anfang einer Versorgungsleitung (16, 19) bestimmter Induktivität (Lx, Ly) verbunden;
- das Ende der Versorgungsleitung ist unmittelbar mit Pufferkondensatoren (18, C) und der Last (17) verbunden,
- die Resonanzfrequenz von der Siebdrossel (21) im Netzteil mit der am Ausgang des Netzteils wirksamen Kapazität (22) ist wesentlich höher als die Resonanzfrequenz von der Leitungsinduktivität (Lx) und dem Pufferkondensator (18, C) unmittelbar an der Last.

2. Anordnung nach Anspruch 1, wobei ferner
- der Gleichspannungsgenerator mit einer Steuerung (24) verbunden ist,
- deren Eingang für den Istwert über eine Fühlleitung (23) mit der Last verbunden ist.

3. Anordnung nach Anspruch 1 oder 2, wobei zwei gleichartige Lasten (17, 17') vorhanden sind, die durch Versorgungsleitungen gleicher Induktivität (Lx, Lx') und gleichen Widerstands gespeist werden.

4. Anordnung nach Anspruch 3, wobei das Netzteil lediglich einen Fühlereingang (SENSE) hat, der über eine Fühlerleitung (23) mit nur einem der beiden Lasten (17') verbunden ist.

5. Anordnung nach Anspruch 3 oder 4, wobei eine Masseleitung in gleicher Art wie die Versorgungsleitung gestaltet ist.

6. Verwendung einer Anordnung nach einem der vorhergehenden Ansprüche, wobei eine im wesentlichen proportionale Regelung des Gleichspannungsgenerators mit der Spannung unmittelbar an der Last als Istwert erfolgt und die Ausgangsspannung des Gleichspannungsgenerators, bedingt durch den Regelvorgang, vorübergehend um mehr als die Hälfte der Sollspannung überschritten werden kann.

## Claims

1. Arrangement for a voltage supply for loads (17) having a high pulsed current requirement, in particular for waveguide terminations, by a power supply unit (20) having the following features:
- the power supply unit (20) contains a DC voltage generator which is connected directly to a first connection of a filter inductor,
- the second connection of the filter inductor (21) is connected to a start of a supply line (16, 19) having a specific inductance (Lx, Ly);
- the end of the supply line is directly connected to buffer capacitors (18, C) and to the load (17);
- the resonant frequency of the filter inductor (21) in the power supply unit together with the capacitance (22) acting at the output of the power supply unit is considerably higher than the resonant frequency of the line inductance (Lx) and the buffer capacitor (18, C) directly connected to the load.

2. Arrangement according to Claim 1, in which, furthermore:
- the DC voltage generator is connected to a controller (24),
- whose input for the actual value is connected via a sensing line (23) to the load.

3. Arrangement according to Claim 1 or 2, in which there are two identical loads (17, 17') which are supplied by supply lines having the same inductance (Lx, Lx') and the same impedance.

4. Arrangement according to Claim 3, in which the power supply unit has only one sensor input (SENSE), which is connected via a sensing line (23) to only one of the two loads (17').

5. Arrangement according to Claim 3 or 4, in which an earth line is designed in the same way as the supply line.

6. Use of an arrangement according to one of the preceding claims, in which the DC voltage generator is subjected to essentially proportional control, with the voltage directly at the load as the actual value, and the output voltage of the DC voltage generator, due to the control process, can be temporarily overshot by more than half the rated voltage.

## Revendications

1. Dispositif d'alimentation en tension de charges (17) ayant un grand besoin de courant par impulsion, notamment de terminaisons de guides d'ondes, par un bloc (20) d'alimentation ayant les caractéristiques :
- le bloc (20) d'alimentation comporte un générateur de tension continue, qui est relié directement à une première borne d'une self de filtrage,
- la deuxième borne de la self (21) de filtrage est reliée à un début d'une ligne (16, 19) d'alimentation d'inductance (Lx, Ly) déterminée ;
- la fin de la ligne d'alimentation est reliée directement à des condensateurs (18, C) d'amortissement et à la charge (17),
- la fréquence de résonance de la self (21) de filtrage du bloc d'alimentation ayant la capacité (22) efficace à la sortie du bloc d'alimentation est sensiblement plus grande que la fréquence de résonance de l'inductance (Lx) de ligne et du condensateur (18, C) d'amortissement directement sur la charge.

2. Dispositif suivant la revendication 1, dans lequel en outre
- le générateur de tension continue est relié à une commande (24),
- dont l'entrée pour la valeur réelle est reliée à la charge par une ligne (23) de détection.

3. Dispositif suivant la revendication 1 ou 2, dans lequel il est prévu deux charges (17, 17') de même type qui sont alimentées par des lignes d'alimentation de même inductance (Lx, Lx') et de même résistance.

4. Dispositif suivant la revendication 3, dans lequel le bloc d'alimentation a simplement une entrée (SENSE) de détecteur qui est reliée par une ligne (23) de détecteur à seulement l'une des deux charges (17').

5. Dispositif suivant la revendication 3 ou 4, dans lequel une ligne de masse est conformée de la même façon que la ligne d'alimentation.

6. Utilisation d'un dispositif suivant l'une des revendications précédentes, une régulation sensiblement proportionnelle du générateur de tension continue s'effectuant en ayant la tension directement sur la charge comme valeur réelle et la tension de sortie du générateur de tension continue, due au processus de régulation, pouvant dépasser transitoirement la valeur de consigne de plus de la moitié.
